# FASCICULE DE BREVET EUROPEEN

(11) **EP 3 224 872 B1**
(45) Date de publication et mention de la délivrance du brevet: **06.05.2020**
(21) Numéro de dépôt: 15800833.4
(22) Date de dépôt: 25.11.2015
(51) Int. Cl.: H01L 31/054, H01L 31/18

(54) **PROCEDE DE FABRICATION D'UN CONCENTRATEUR PHOTOVOLTAÏQUE A STRUCTURE OPTIQUE MUNIE DE DEUX ETAGES DE LENTILLES OPTIQUES**
VERFAHREN ZUR HERSTELLUNG EINES FOTOVOLTAIKONZENTRATORS MIT EINER OPTISCHEN STRUKTUR MIT ZWEISTUFIGEN OPTISCHEN LINSEN
METHOD FOR PRODUCING A PHOTOVOLTAIC CONCENTRATOR WITH AN OPTICAL STRUCTURE PROVIDED WITH TWO STAGES OF OPTICAL LENSES

(30) Priorité: 26.11.2014 FR 1461500
(43) Date de publication de la demande: 04.10.2017
(73) Titulaire: COMMISSARIAT À L'ÉNERGIE ATOMIQUE ET AUX ÉNERGIES ALTERNATIVES, 75015 Paris (FR)
(72) Inventeur: DOMINGUEZ, Cesar, 38300 Bourgoin-Jallieu (FR)
(74) Mandataire: Novaimo
(86) Numéro de dépôt international: PCT/EP2015/077631
(87) Numéro de publication internationale: WO 2016/083446

(56) Documents cités:
- EP-A1- 2 139 046
- US-A1- 2012 273 025
- US-A1- 2014 261 625
- US-A1- 2014 261 683

## Description

### Domaine technique de l'invention

L'invention concerne le domaine des concentrateurs photovoltaïques.

L'invention a pour objet plus particulièrement un procédé de fabrication d'un concentrateur photovoltaïque.

Encore un autre objet de l'invention concerne un moule en particulier destiné à être utilisé dans le procédé de fabrication.

### État de la technique

Il est connu que la concentration de l'énergie solaire sur une cellule photovoltaïque permet d'améliorer son rendement et de réduire la quantité de matériaux semi-conducteurs onéreux en les remplaçant par des matériaux optiques moins onéreux. Ainsi, la littérature enseigne de nombreuses solutions mettant en oeuvre des systèmes à base de lentilles pour concentrer un rayon lumineux vers une surface active d'une cellule photovoltaïque.

Le document US6,804,062 enseigne notamment l'utilisation de deux lentilles formées indépendamment l'une de l'autre à partir de moules adaptés.

Le document « Micro-concentrators for a microsystems-enabled photovoltaic system » de Bradley H. Jared et al. publié dans OPTICS EXPRESS A521 Vol. 22, No. S2 daté du 10 mars 2014 décrit notamment l'utilisation d'un concentrateur optique à deux étages de lentilles en polycarbonate. La fabrication de ce concentrateur optique requiert l'utilisation de deux moules distincts présentant des repères permettant de mouler des éléments de guidage en vue de l'alignement après démoulage des deux étages de lentilles.

La fabrication d'un tel concentrateur optique requiert des étapes de moulages distinctes, et peut poser des problèmes quant à l'alignement des étages d'optiques issus de ces moules distincts.

Le document US2012/273025 décrit un concentrateur optique comprenant une optique primaire et une optique secondaire.

### Objet de l'invention

Le but de la présente invention est de proposer une solution qui remédie à tout ou partie des inconvénients listés ci-dessus.

On tend vers ce but grâce à un procédé de fabrication d'un concentrateur photovoltaïque selon la revendication 1 comprenant un substrat photovoltaïque muni d'une pluralité de cellules photovoltaïques, et une structure optique comprenant un premier étage de lentilles optiques et un deuxième étage de lentilles optiques destinés à coopérer optiquement entre eux, ledit procédé comportant les étapes suivantes :
- une fourniture d'un moule,
- une formation simultanée du premier étage de lentilles optiques et du deuxième étage de lentilles optiques utilisant ledit moule fourni et mettant en œuvre une étape de remplissage dudit moule par un matériau, notamment par injection ou par coulée dudit matériau.

En particulier, l'étape de fourniture dudit moule est telle que ledit moule fourni comporte une première face munie d'une pluralité de premières cavités délimitant chacune une forme complémentaire à celle d'une lentille optique correspondante du premier étage de lentilles optiques et une deuxième face munie d'une pluralité de deuxièmes cavités délimitant chacune une forme complémentaire à celle d'une lentille optique correspondante du deuxième étage de lentilles optiques.

Avantageusement, le procédé comporte les étapes suivantes mises en œuvre avant l'étape de remplissage :
- un report ou une mise en place du substrat photovoltaïque sur la deuxième face du moule de telle sorte que chaque cellule photovoltaïque soit placée dans une deuxième cavité correspondante,
- un report ou une mise en place d'une paroi transparente sur la première face du moule.

Notamment, l'étape de remplissage comporte une étape de guidage du matériau de telle sorte que le matériau vienne remplir chacune des premières cavités et chacune des deuxièmes cavités.

Par exemple, l'étape de guidage comporte l'utilisation d'un réseau de canaux d'écoulement dudit matériau formés dans la deuxième face du moule pour remplir chacune des deuxièmes cavités.

Selon une réalisation, les cellules photovoltaïques étant reliées électriquement entre elles par des éléments de liaison électrique formés à la surface du substrat photovoltaïque portant les cellules photovoltaïques, l'étape de guidage permet le remplissage du réseau de canaux par le matériau d'où il résulte une encapsulation des éléments de liaison électrique par ledit matériau après durcissement dudit matériau.

Le procédé peut comporter une étape de retrait dudit moule comprenant une désolidarisation du premier étage de lentilles optiques formé par rapport au deuxième étage de lentilles optiques formé, l'étape de retrait dudit moule étant suivie d'une étape d'assemblage du premier étage de lentilles optiques avec le deuxième étage de lentilles optiques.

Avantageusement, le procédé comporte une étape de mise en référencement du substrat photovoltaïque par rapport à la paroi transparente réalisée avant durcissement du matériau pour permettre, après démoulage dudit moule, la mise en oeuvre de l'étape d'assemblage selon un alignement correspondant à ladite mise en référencement du deuxième étage de lentilles optiques fixé au substrat photovoltaïque par rapport au premier étage de lentilles optiques fixé à ladite paroi transparente.

Selon une réalisation, le matériau utilisé par l'étape de remplissage est un polymère transparent apte à être mis en forme par coulée ou par injection, notamment un polymère durcissable après coulée ou injection.

Si l'étape de remplissage est réalisée par coulée du matériau dans le moule, ledit matériau est un PDMS. Alternativement, si l'étape de remplissage est réalisée par injection du matériau dans le moule ledit matériau est un PC ou PMMA.

L'invention est aussi relative à un moule selon la revendication 10 pour la fabrication d'une structure optique du concentrateur photovoltaïque, ladite structure optique comprenant un premier étage de lentilles optiques et un deuxième étage de lentilles optiques destinés à coopérer optiquement entre eux, ledit moule comportant une première face munie d'une pluralité de premières cavités délimitant chacune une forme complémentaire à celle d'une lentille optique correspondante du premier étage de lentilles optiques et une deuxième face munie d'une pluralité de deuxièmes cavités délimitant chacune une forme complémentaire à celle d'une lentille optique correspondante du deuxième étage de lentilles optiques.

Le moule peut comporter un réseau de canaux formé dans la deuxième face et destiné au remplissage desdites deuxièmes cavités, ledit réseau de canaux étant configuré de sorte que son remplissage vienne encapsuler des éléments de liaison électrique reliant électriquement des cellules photovoltaïques d'un substrat photovoltaïque du concentrateur photovoltaïque.

L'invention est aussi relative à un concentrateur optique comprenant une structure optique comprenant un premier étage de lentilles optiques et un deuxième étage de lentilles optiques destinés à coopérer optiquement entre eux, la structure optique étant monobloc ou venue d'une même pièce.

L'invention est encore relative à un concentrateur photovoltaïque comprenant un substrat photovoltaïque muni d'une pluralité de cellules photovoltaïques, et une structure optique comprenant un premier étage de lentilles optiques et un deuxième étage de lentilles optiques destinés à coopérer optiquement entre eux, la structure optique étant monobloc ou venue d'une même pièce.

L'invention se rapporte enfin à un concentrateur photovoltaïque obtenu par la mise en œuvre du procédé de fabrication défini précédemment.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue de côté d'un concentrateur photovoltaïque formé selon une réalisation de l'invention,
- la figure 2 est une vue en coupe réalisée au niveau du moule utilisé pour former simultanément les deux étages de lentilles de la structure optique du concentrateur,
- la figure 3 illustre une vue en perspective d'une réalisation particulière d'un moule utilisé dans le procédé de fabrication selon l'invention,
- la figure 4 est une vue de dessus du moule de la figure 3 orientée vers une face destinée au moulage du premier étage de lentilles,
- la figure 5 est une vue de dessous du moule de la figure 3 orientée vers une face destinée au moulage du deuxième étage de lentilles,
- la figure 6 est une vue en coupe selon A-A de la figure 4.

### Description de modes préférentiels de l'invention

Le procédé de fabrication d'un concentrateur photovoltaïque à structure optique décrit ci-après diffère de l'art antérieur notamment en ce que les deux étages de lentilles optiques sont obtenus à partir d'un même moule, et notamment de manière simultanée.

Par « les deux étages de lentilles optiques sont obtenus de manière simultanée », on entend que leurs formations sont réalisées à partir d'une même étape de remplissage dudit moule, notamment par injection ou par coulée, d'un matériau adapté au moulage des étages de lentilles optiques. Il en résulte que ces deux étages de lentilles optiques peuvent être obtenus à partir d'une étape unique de remplissage, ce qui permet de rationaliser la fabrication de la structure optique (moins d'étapes, éviter de devoir gérer des références distinctes de moules, etc.).
Dans la présente description, un concentrateur photovoltaïque comporte une structure optique, aussi appelée concentrateur optique, et un substrat photovoltaïque muni de cellules photovoltaïques.

Un concentrateur optique à deux étages de lentilles optiques permet d'augmenter le ratio de concentration entre la plus grosse des lentilles (aussi appelée lentille primaire et devant collecter la lumière de sorte à la concentrer en direction de la lentille secondaire) et une cellule photovoltaïque correspondante d'un substrat, tout en augmentant la tolérance angulaire du substrat photovoltaïque par rapport à la normale du soleil. Par rapport à un concentrateur photovoltaïque à un seul étage de lentilles, l'utilisation de deux étages permet de tendre plus facilement vers la concentration maximale théorique de la lumière, cette concentration maximale étant donnée par le théorème de la conservation de l'étendue.

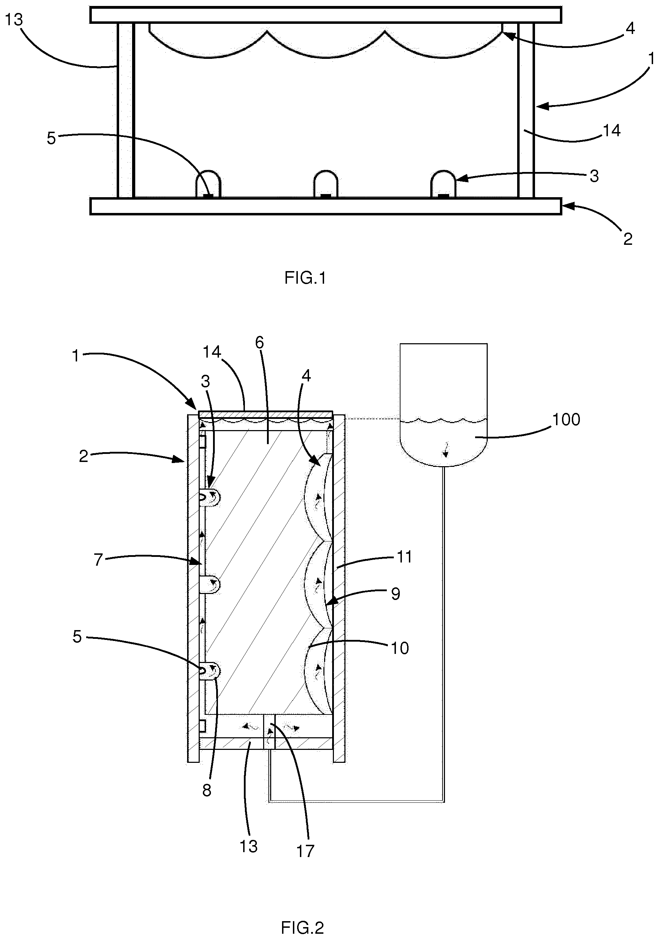

La figure 1 illustre un concentrateur photovoltaïque comprenant une structure optique 1 et un substrat photovoltaïque 2 muni d'une pluralité de cellules photovoltaïques 5. La structure optique 1 comprend un premier étage de lentilles optiques 4 (aussi appelé étage primaire dans le domaine) et un deuxième étage de lentilles optiques 3 (aussi appelé étage secondaire dans le domaine) destinés à coopérer optiquement entre eux.

La coopération optique entre les premier et deuxième étages de lentilles optiques 4, 3 peut-être telle qu'un faisceau/rayonnement lumineux entrant avec une incidence normale dans une lentille du premier étage de lentilles optiques 4 est dévié de sorte à converger sur une lentille correspondante du deuxième étage de lentilles optiques 3. Plus particulièrement, on dit que la lumière est normale au concentrateur photovoltaïque selon un angle de plus ou moins un degré (typiquement dans le cadre de concentration supérieure à 100 fois) dans le but d'atteindre une cellule photovoltaïque 5.

En particulier, le deuxième étage de lentilles optiques 3 est destiné à être fixé au substrat photovoltaïque 2, notamment au cours du moulage du deuxième étage de lentilles optiques 3. Chaque lentille du deuxième étage de lentilles optiques 3 forme notamment une lentille reposant sur une (notamment une seule) cellule photovoltaïque 5 du substrat photovoltaïque 2. On comprend alors que chaque lentille optique du premier étage de lentilles optiques 4 est alors configurée de sorte à faire converger le rayonnement lumineux d'incidence normale correspondant en direction d'une lentille du deuxième étage de lentilles optiques 3 qui elle-même fait converger le rayonnement lumineux reçu vers la cellule photovoltaïque 5 sur laquelle elle repose. Généralement, pour permettre la concentration optique souhaitée, les lentilles optiques du premier étage de lentilles optiques 4 ont une surface supérieure à la surface des lentilles optiques du deuxième étage de lentilles optiques 3.

En particulier, le substrat photovoltaïque 2 peut comporter au moins un support rigide, réalisé notamment à base de Polyméthacrylate de méthyle PMMA ou de verre ou même analogue à un circuit imprimé dans le cas d'un microconcentrateur. Le support est destiné à porter les cellules photovoltaïques 5, et des éléments de liaison électrique (non représentés) reliant électriquement les cellules photovoltaïques 5 entre elles, notamment en série pour réduire le courant total, et par conséquent les pertes dues à la résistance série (pertes ohmiques). Le substrat photovoltaïque 2 peut avoir subit un traitement pour favoriser l'accroche d'un matériau qui sera utilisé pour mouler le deuxième étage de lentilles 3 (traitement plasma ou corona), ce traitement est notamment utilisé lorsque les matériaux formant le circuit imprimé sont du type PMMA ou verre, et dans le cadre où les lentilles optiques du deuxième étage de lentilles optiques 3 seront moulées directement sur le substrat photovoltaïque 2 pour encapsuler chaque cellule photovoltaïque 5 correspondante. Notamment, chaque lentille du deuxième étage de lentilles optique 3 encapsule une cellule photovoltaïque correspondante.

Comme l'illustre la figure 2, le procédé de fabrication du concentrateur photovoltaïque tel que décrit comporte une étape de fourniture d'un moule 6 et une étape de formation simultanée du deuxième étage de lentilles optiques 3 et du premier étage de lentilles optiques 4 utilisant ledit moule fourni 6 et mettant en œuvre une étape de remplissage dudit moule 6 fourni par d'un matériau 100. En particulier, la formation simultanée met en œuvre une étape unique de remplissage dudit moule 6 fourni par d'un matériau 100. Notamment, l'étape de remplissage est réalisée par injection ou par coulée dudit matériau 100.

En fait, le matériau 100 utilisé par l'étape de remplissage peut être un polymère transparent apte à être mis en forme par coulée ou par injection. Notamment ce polymère peut être durcissable après coulée ou injection. Le moulage par injection utilise une mise en pression du matériau 100 ce qui n'est pas de le cas de la technique de moulage par coulée. Dans le cas où l'étape de remplissage est réalisée par coulée du matériau dans le moule fourni 6, alors le matériau 100 est un PDMS (Polydiméthylsiloxane). Dans le cas où l'étape de remplissage est réalisée par injection du matériau 100 dans ledit moule fourni 6 alors le matériau est un PC (Polycarbonate) ou PMMA (Polyméthacrylate de méthyle).

Chacune des lentilles du deuxième étage de lentilles optiques 3 peut adopter la forme d'un dôme dont la partie convexe est orientée vers le premier étage de lentilles optiques 4. Les lentilles du deuxième étage de lentilles optiques 3 peuvent avoir une ouverture circulaire asphérique (c'est-à-dire que la forme est libre tout en possédant une symétrie à axe de rotation). Selon une variante, les lentilles du deuxième étage de lentilles peuvent être de type CPC (concentrateur parabolique composé) ou DTIR (d'après le sigle en anglais de « matériau Dielectric avec de la Réflexion Interne Totale ») permettant des concentrations géométriques plus proches des maxima théoriques, mais dans ce cas le matériau utilisé pour former lesdites lentilles devra avoir une élasticité suffisante pour autoriser un démoulage adéquat sans endommager lesdites lentilles (dans ce cas un matériau de type PDMS peut remplir le moule 6 par coulée).

Chacune des lentilles optiques du premier étage de lentilles optiques 4 peut adopter la forme d'une lentille de concentration asphérique plan-convexe à ouverture carrée dont la partie convexe est orientée vers le deuxième étage de lentilles optiques 3. Le nombre d'ouverture (F-number en anglais) de chaque lentille du premier étage de lentilles optiques 4 est proche de 1 (c'est-à-dire entre 1 et 2). Du fait d'une zone d'ouverture très petite, le volume d'une lentille du premier étage de lentilles 4 est très petit même si elle n'est pas tronquée pour former des facettes de Fresnel qui introduisent des pertes optiques et rendent plus difficile le démoulage du moule.

Il en résulte que le moule 6 comporte des empreintes négatives (ou cavités) permettant de réaliser ces lentilles optiques du premier étage et du deuxième étage. De préférence, pour faciliter le démoulage, les cavités destinées à former les lentilles optiques sont préparées en dépouille, c'est-à-dire qu'elles sont creusées perpendiculairement et non en talus. Autrement dit, afin de faciliter l'extraction des premier et deuxième étages de lentilles optiques 4, 3 du moule 6, ou afin de ne pas arracher de la matière lors de l'extraction des premier et deuxième étages de lentilles optiques 4, 3, aucune face des premier et deuxième étages de lentilles optiques 3, 3 formée par le matériau, notamment coulé ou injecté, durci ne doit être strictement perpendiculaire au plan de joint du moule (autrement dit, aucune face ne doit être strictement parallèle à la direction d'ouverture du moule). Ainsi, pour pouvoir démouler, aucune face ne doit comporter de dépouille négative. Si le matériau utilisé présente une élasticité suffisante après son durcissement (notamment le PDMS remplissant le moule par coulée), des cavités creusées en talus pourront aussi être utilisées.

Selon l'invention, le moule 6 fourni est tel qu'il permet de mouler le premier étage de lentilles optiques 4 et le deuxième étage de lentilles optiques 3 d'une manière telle que le positionnement du premier étage de lentilles optiques 4 dans le moule 6 par rapport au deuxième étage de lentilles optiques 3 dans le moule 6 correspond au positionnement désiré du premier étage de lentilles optiques 4 par rapport au deuxième étage de lentilles optiques 3 dans une configuration d'assemblage du concentrateur photovoltaïque. Selon une alternative le moulage est tel qu'il suffit juste de jouer sur l'écart entre les premier et deuxième étages de lentilles optiques pour obtenir la configuration d'assemblage. L'utilisation d'un tel moule 6 permet notamment par la suite de participer à un alignement adapté entre le premier étage de lentilles optiques 4 et le deuxième étage de lentilles optiques 3 en prenant en compte cet alignement dès la fabrication.

La configuration d'assemblage décrite ci-dessus correspond à celle dans laquelle le concentrateur photovoltaïque est censé fonctionner lorsqu'il est orienté vers un rayonnement solaire de sorte à le concentrer sur les cellules photovoltaïques 5 du substrat photovoltaïque 2.

On comprend de ce qui a été dit précédemment que l'étape de remplissage est telle que le matériau 100, notamment injecté ou coulé, vient remplir des cavités dudit moule 6. Tout ou partie de ces cavités adopte les formes désirées desdites lentilles optiques du premier étage de lentilles optiques 4 et du deuxième étage de lentilles optiques 3.

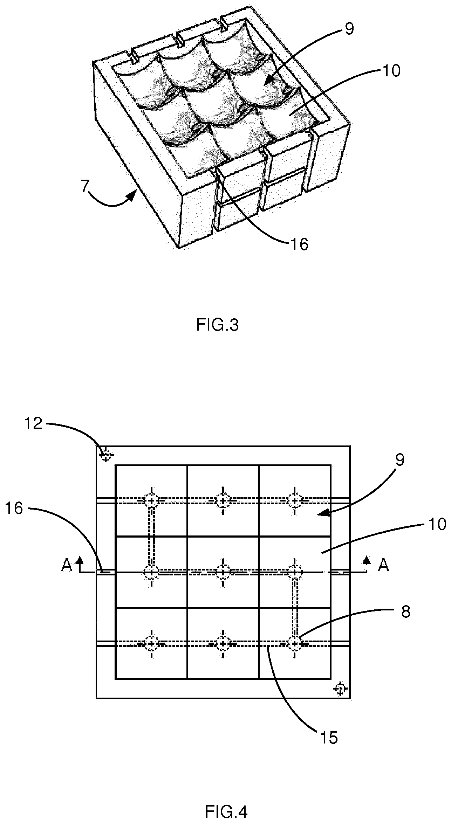

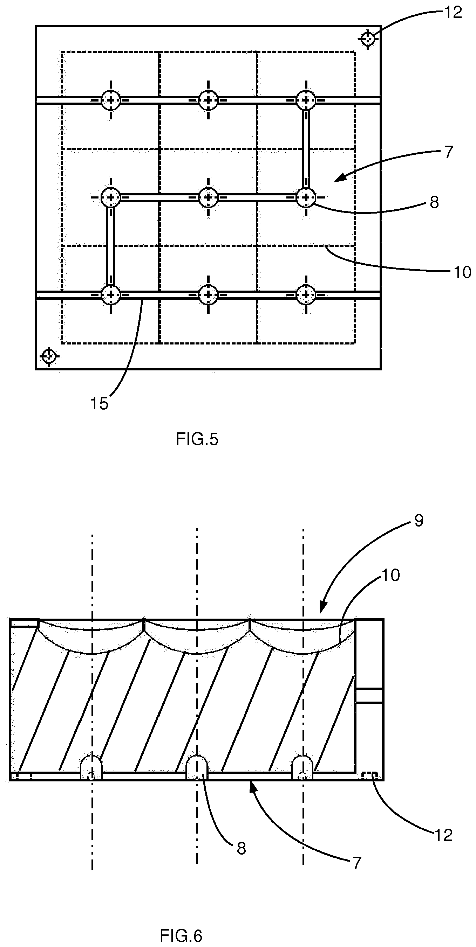

Les figures 2 à 6 illustrent une réalisation particulière dudit moule fourni 6. En particulier, l'étape de fourniture dudit moule 6 est telle que ledit moule fourni 6 comporte une première 9 face munie d'une pluralité de premières cavités 10 (aussi appelée cavités primaires dans le domaine). Chaque cavité de la pluralité de premières cavités 10 délimite une forme complémentaire à celle d'une lentille optique correspondante du premier étage de lentilles optiques 4. Ledit moule 6 comporte en outre une deuxième face 7 munie d'une pluralité de deuxièmes cavités 8 (aussi appelées cavités secondaires dans le domaine). Chaque cavité 8 de la deuxième pluralité de cavités optique délimite une forme complémentaire à celle d'une lentille optique correspondante du deuxième étage de lentilles optiques 3. Aux figures 4 et 5, les pointillés représentent les éléments non visibles des faces 7, 9 cachées. Ces première et deuxième face 9, 7 sont opposées, notamment de telle sorte à réaliser le moulage des premier et deuxièmes étages de lentilles optiques selon un positionnement correspondant à celui du concentrateur optique assemblé et dont prêt à être utilisé.

Selon une mise en œuvre illustrée en figure 2, le procédé de fabrication du concentrateur photovoltaïque comporte les étapes suivantes mises en œuvre avant l'étape de remplissage du moule 6 fourni par le matériau 100: un report du substrat photovoltaïque 2 sur la deuxième face 7 du moule 6 de telle sorte que chaque cellule photovoltaïque 5 du substrat photovoltaïque 2 soit placée dans une deuxième cavité 8 correspondante (notamment, après report du substrat photovoltaïque 2, chaque deuxième cavité 8 comporte une unique cellule photovoltaïque 5 en particulier placée au foyer de la future lentille du deuxième étage de lentilles optiques 3 formée par le remplissage de ladite deuxième cavité 8), et un report d'une paroi transparente 11 sur la première face 9 du moule 6.

Dans la présente description, la paroi transparente 11 est considérée comme transparente au rayonnement lumineux que l'on va chercher à concentrer sur les cellules photovoltaïques 5, notamment elle est transparente aux rayonnements dont la longueur d'onde est comprise entre 300 nanomètres et 1800 nanomètres, soit la gamme spectrale à laquelle les cellules photovoltaïques multijonction à base de germanium cristallin sont sensibles. Il en résulte que les lentilles du premier étage de lentilles et du deuxième étage de lentilles sont aussi préférentiellement transparentes en particulier audit rayonnement lumineux notamment dans la gamme de longueurs d'onde susmentionnée.

Le substrat photovoltaïque 2 et la paroi transparente 11 reportés viennent fermer le moule 6 de sorte à délimiter le volume de chaque deuxième et première cavité 8, 10 à remplir par le matériau 100, notamment à injecter ou à couler.

Notamment, le matériau 100, une fois dans le moule 6, notamment par coulée ou par injection, et durci, fixe le substrat photovoltaïque 2 au deuxième étage de lentilles optiques 3 et fixe la paroi transparente 11 au premier étage de lentilles optiques 4. Autrement dit, il résulte de l'étape de remplissage du moule 6 par le matériau 100 et du durcissement du matériau 100, notamment injecté ou coulé, qu'après démoulage du moule 6, le deuxième étage de lentilles optiques 3 est fixé audit substrat photovoltaïque 2 et que le premier étage de lentilles optiques 4 est fixé à ladite paroi transparente 11. Ainsi, le moulage selon l'invention permet de réaliser les lentilles optiques directement sur leurs supports contrairement à l'art antérieur qui nécessite, après démoulage, des étapes supplémentaires de report sur leurs supports.

Après report du substrat photovoltaïque 2 et de la paroi transparente 11, le procédé peut comporter une étape de verrouillage du substrat photovoltaïque 2 et de la paroi transparente 11 par rapport au moule 6 pour éviter leurs déplacements relatifs au cours de l'étape de remplissage du moule par le matériau 100 et au cours du durcissement du matériau 100, notamment coulé ou injecté. En effet, tout déplacement aurait pour conséquences le désalignement entre les deux étages optiques.

De préférence, le moule 6 comporte des éléments de positionnement 12 (visibles aux figures 4 à 6) configurés de sorte à coopérer avec des éléments de positionnement du substrat photovoltaïque 2 pour assurer que chaque cellule photovoltaïque 5 soit positionnée dans une des deuxièmes cavités 8 correspondante, et qu'après moulage de la lentille associée du deuxième étage de lentilles optiques 3, elle soit positionnée au foyer de ladite lentille. Selon un exemple non limitatif, les éléments de positionnement 12 du moule 6 sont des trous et les éléments de positionnement du substrat photovoltaïque 2 sont des ergots configurés de sorte à pénétrer les trous du moule 6. Autrement dit, l'étape de report du substrat photovoltaïque 2 sur la deuxième face 7 peut comporter une étape de positionnement du substrat photovoltaïque 2 par rapport au moule 6 pour obtenir le positionnement adapté décrit ci-dessus.

En outre, pour permettre de faciliter l'assemblage du concentrateur optique après démoulage du moule 6, le procédé peut comporter, avant l'étape de formation des deux étages de lentilles optiques 3, 4, le report ou la mise en place d'entretoises 13, 14 (figure 2) en contact avec la paroi transparente 11 et le substrat photovoltaïque 2 pour assurer leur espacement adapté à celui après assemblage du concentrateur optique consécutivement au retrait du moule 6 et/ou un référencement de positionnement entre la paroi transparente 11 et le substrat photovoltaïque 2. Il en résulte que ces entretoises 13, 14 pourront être utilisées après démoulage des premier et deuxième étages de lentilles optiques 4, 3 pour assurer une distance de séparation adaptée entre lesdits premier et deuxième étages de lentilles optiques 4, 3 au cours d'une étape d'assemblage du concentrateur optique comme représenté en figure 1. Notamment, de la colle (par exemple un adhésif en élastomère silicone) peut être utilisée pour fixer les entretoises 13, 14 au substrat photovoltaïque 2 et à la paroi transparente 11 après démoulage. Avantageusement, l'étape de remplissage du moule 6 par le matériau 100 est notamment telle qu'elle vient combler les cavités décrites ci-dessus et destinées à former les lentilles des premier et deuxième étages optiques 4, 3. Il en résulte que la formation du deuxième étage de lentilles optiques 3 réalise concomitamment une encapsulation desdites cellules photovoltaïques 5, les protégeant ainsi des poussières et de l'humidité lorsque le matériau 100, notamment injecté ou coulé, durci fixe le deuxième étage de lentilles optiques 3 au substrat photovoltaïque 2.

Selon un perfectionnement, l'étape de remplissage du moule 6 par le matériau 100 comporte une étape de guidage du matériau 100, notamment injecté ou coulé, de telle sorte que le matériau 100, notamment injecté ou coulé, vienne remplir chacune des premières cavités 10 et chacune des deuxièmes cavités 8. Notamment, l'étape de guidage comporte l'utilisation d'un réseaux de canaux 15 (figures 4 et 5) d'écoulement dudit matériau 100, notamment injecté ou coulé, formés dans la deuxième face 7 du moule 6 pour remplir chacune des deuxièmes cavités 8 et/ou au moins un canal 16 formé dans la première face 9 du moule 6 (figures 3 et 4) et reliant une des premières cavités 10. Le réseau de canaux 15 permet notamment de relier les deuxièmes cavités 8 entre elles de sorte à les remplir lorsque le substrat photovoltaïque 2 est reporté sur le moule 6. Concernant les premières cavités 10, elles sont préférentiellement en communication directe, ainsi le guidage se fait naturellement d'une cavité 10 à une autre cavité 10, notamment selon la technique des vases communicants, lorsque la paroi transparente 11 est reportée sur le moule 6.

Avantageusement pour favoriser le démoulage, les canaux du moule 6 sont préparés en dépouille.

Selon un exemple, lorsque le substrat photovoltaïque 2 et la paroi transparente 11 sont reportés sur le moule 6, le matériau 100 peut être injecté ou coulé dans une chambre correspondante 17 (figure 2) répartissant le matériau par l'utilisation des canaux 15, 16 décrits précédemment qui sont alors en communication avec ladite chambre 17. Selon l'exemple particulier, la chambre 17 peut être disposée sur un côté du moule 6, et être au moins en partie délimitée par l'entretoise 13 visée précédemment, la paroi transparente 11 et le substrat photovoltaïque 2.

Selon une réalisation évoquée précédemment, les cellules photovoltaïques 5 peuvent être reliées électriquement entre elles par des éléments de liaison électrique, notamment des pistes par exemple en cuivre, formés à la surface du substrat photovoltaïque 2 portant lesdites cellules photovoltaïques 5. Dès lors, le moule 6 peut comporter des canaux liant les deuxièmes cavités 8 (il peut alors s'agir du réseau de canaux 15 décrit précédemment) de telle sorte que le matériau 100, notamment injecté ou coulé, remplisse lesdits canaux et les deuxièmes cavités 8. Il en résulte qu'après durcissement du matériau 100 fixé au substrat photovoltaïque 2, ce dernier encapsule à la fois les éléments de liaison électriques et les cellules photovoltaïques. Autrement dit, l'étape de guidage du matériau 100, notamment injecté ou coulé, peut permettre le remplissage du réseau de canaux 15 par le matériau 100 d'où il résulte une encapsulation des éléments de liaison électrique (et notamment des cavités 8) par ledit matériau 100 après durcissement dudit matériau 100 (assurant ainsi une protection contre la poussière et l'humidité). On peut alors dire que le moule 6 peut comporter ledit réseau de canaux 15 configuré de sorte que son remplissage vienne encapsuler des éléments de liaison électrique reliant électriquement les cellules photovoltaïques 5 du substrat photovoltaïque 2. Il est clair que dans ce cas lorsque le substrat photovoltaïque 2 est reporté sur le moule 6, les éléments de liaison électrique sont placés dans les canaux du réseau de canaux 15.

Selon une mise en œuvre, le procédé comporte une étape de retrait dudit moule 6 comprenant une désolidarisation du deuxième étage de lentilles optiques 3 formé, et notamment fixé au substrat photovoltaïque 2, par rapport au premier étage de lentilles optiques 4 formé, et notamment fixé à la paroi transparente 11. L'étape de retrait dudit moule 6 est suivie de l'étape d'assemblage du premier étage de lentilles optiques 4 avec le deuxième étage de lentilles optiques 3 de sorte à former la structure optique 1. Il est clair que cette étape de retrait est réalisée après durcissement du matériau 100, notamment injecté ou coulé, préférentiellement alors que ce dernier rempli chacune des deuxièmes cavités 8 et chacune des premières cavités 10, et le cas échéant les canaux ou réseaux de canaux décrits précédemment.

On comprend de ce qui a été dit ci-dessus que l'étape d'assemblage va préférentiellement nécessiter une précision importante pour optimiser le positionnement des foyers des lentilles optiques du premier étage de lentilles optiques 4 par rapport au deuxième étage de lentilles optiques 3, et donc la concentration au niveau des cellules photovoltaïques 5. En ce sens, le procédé de fabrication peut comporter une étape de mise en référencement du substrat photovoltaïque 2 par rapport à la paroi transparente 11 réalisée avant durcissement du matériau 100, notamment injecté ou coulé, (et notamment avant le remplissage du moule par le matériau 100) pour permettre, après démoulage dudit moule 6, la mise en œuvre de l'étape d'assemblage selon un alignement correspondant à ladite mise en référencement du deuxième étage de lentilles optiques 3 fixé au substrat photovoltaïque 2 par rapport au premier étage de lentilles optiques 4 fixé à ladite paroi transparente 11.

Cette étape de mise en référencement peut notamment utiliser tout ou partie des éléments suivants : lesdits éléments de positionnement évoqués précédemment, les entretoises évoquées précédemment. En outre cette étape de référencement peut utiliser une pièce externe servant de gabarit comme une pièce formant un angle droit qui sera à nouveau utilisée lors de l'assemblage du concentrateur optique/photovoltaïque après démoulage. Cette pièce externe peut comporter deux pans reliés entre eux pour former une équerre en contact avec un angle droit du substrat et un angle droit de la paroi transparente. Alternativement, la pièce externe peut comporter des pointes coopérant avec le substrat 2 et la paroi transparente 11 pour permettre un positionnement sans ambiguïté correspondant à la configuration d'assemblage visée précédemment.

L'architecture de la structure optique 1 décrite selon la présente invention peut notamment autoriser des niveaux de concentration bas, moyens ou hauts. Un niveau bas est considéré comme permettant de multiplier entre 2 et 100 fois la valeur standard d'irradiance solaire de 0,1W/cm². Un niveau moyen est considéré comme permettant de multiplier entre 100 et 300 fois la valeur standard d'irradiance solaire de 0,1W/cm². Un niveau haut est considéré comme permettant de multiplier entre 300 et 1000 fois la valeur standard d'irradiance solaire de 0,1W/cm².

Avantageusement, l'ouverture optique de chacune des lentilles est minimisée (par « minimisée », on entend qu'elle peut aller de quelques millimètres à quelques centimètres) de sorte à minimiser la quantité de chaleur au niveau des cellules photovoltaïques (la quantité maximale de chaleur peut alors être de 1W dans le cadre de lentilles primaires de 3cm par 3cm), du fait de la concentration, à dissiper. Ceci permet notamment d'éviter de devoir monter des dissipateurs thermiques sous le substrat photovoltaïque, et donc de diminuer les coûts.

De manière générale, la fabrication du moule 6 peut impliquer un usinage de précision d'une pièce, par exemple un bloc d'aluminium notamment de type 7075. L'usinage sera réalisé pour former les pluralités de premières et deuxièmes cavités 10, 8 décrites précédemment, les éventuels canaux 15, 16 évoqués précédemment, et les éventuels éléments de positionnement évoqués précédemment.

Les cavités 8, 10 et/ou les canaux 15, 16 peuvent être usinés en utilisant les techniques de l'usinage au diamant.

Il est clair que le moule sera réalisé de telle sorte à présenter des surfaces lisses pour favoriser le démoulage. A titre d'exemple, l'usinage au diamant d'aluminium 7075 permet d'obtenir une rugosité inférieure à 5nm avant d'être recouvert d'une couche antiadhésive comme par exemple une couche en nickel, en nitrure de bore et de nickel, en nickel Polytetrafluoroethylene (PTFE) ou en perfluorodecyltrichlorosilane (FDTS).

Selon une variante, le moule peut aussi être en Polyméthacrylate de méthyle (PMMA), cette variante présente l'avantage de réduire l'adhésion avec le matériau 100 durci lorsque ce dernier est du PDMS.

De manière applicable à tout ce qui a été dit ci-dessus, le matériau 100 peut être à base de silicone. Notamment, le matériau 100 est du Polydiméthylsiloxane (PDMS). Le matériau 100 peut être obtenu par mélange de deux composants A et B d'élastomère silicone dans un réservoir auquel un vide est appliqué pour retirer les bulles du matériau 100 avant remplissage du moule pour éviter leurs présence dans les lentilles optiques. Le PDMS présente l'avantage d'avoir une stabilité aux températures élevées (au-delà de 260°C), et une très bonne transmission des rayonnements lumineux ainsi qu'une bonne résistance aux dégradations causées par les ultraviolets.

Le moule 6 peut notamment être rempli par le matériau 100 (étape de remplissage), notamment par du PDMS, placé à pression hydrostatique permettant un coulage par vase communiquant. Et le matériau 100 peut être durci à une température comprise entre 25 °C et 60°C (l'élastomère silicone bicomposants est vulcanisable à froid et/ou à basse température de l'ordre de 40°C à 60°C).

Le substrat photovoltaïque 2 et/ou la paroi transparente 11 ont préférentiellement subis un traitement favorisant l'accroche du matériau 100, notamment au cours de sa polymérisation si le matériau est du PDMS, avant leurs reports sur le moule 6. Ce traitement peut notamment être le même que celui évoqué précédemment pour le substrat photovoltaïque 2, et alternativement il peut s'agir d'un dépôt d'un apprêt primaire adapté au PDMS et la surface d'accroche (par exemple un produit tel le Wacker Primer G 790 ®). Le dépôt du Wacker Primer G 790 ® peut être appliqué avec un ratio de poids/surface de 50g/m² et être suivi d'une phase d'évaporation d'une à deux heures à température ambiante de 25°C à 40% d'humidité.

Selon un exemple particulier, le matériau 100 est du Wacker Elastosil RT 601 ® utilisé en tant que silicone en mélangeant les composants A et B dans un ratio de poids de 9 :1. Le Dow Corning Sylgard 184 ® peut aussi être utilisé dans un ratio de poids des composants A et B de 10 :1.

Les produits visés ci-dessus sont plus généralement des élastomères silicones transparents (PDMS) bicomposants vulcanisables à froid (EVF) ou à une température comprise entre 40°C et 60°C. Au minimum, le matériau 100 durci doit être transparent sur la plage spectrale 300nm - 1800nm et résistants aux rayons ultraviolets concentrés.

De manière générale, quel que soit le matériau 100 utilisé, il présente préférentiellement une faible viscosité de 3.5Pa.s au moment du remplissage du moule 6 de sorte à permettre un remplissage approprié des cavités du moule 6.

Selon une mise en œuvre du procédé de fabrication, le moule 6 et notamment le substrat photovoltaïque 2 ainsi que la paroi transparente 11 sont refroidis au cours de l'étape de remplissage du moule 6 par le matériau 100 de sorte à retarder sa polymérisation pour assurer un remplissage adéquat du moule 6 et en particulier un dégazage du mélange formant le matériau 100. Ceci est notamment nécessaire si le remplissage de toutes les cavités au travers des canaux est moins rapide que sa polymérisation (notamment lorsqu'il s'agit de PDMS).

Selon un perfectionnement, le matériau 100 est durci, après remplissage du moule 6, à une température correspondant à une température souhaitée de fonctionnement du substrat photovoltaïque 2 équipé de la structure optique 1 dans le but de réduire les pertes optiques à cause d'un décalage des coefficients thermiques d'expansion entre les différents matériaux des lentilles, du substrat photovoltaïque 2 et de la paroi transparente 11.

Un tel concentrateur optique 1 permet la réalisation des modules photovoltaïques à concentration à bas-couts, des modules photovoltaïques à poids adaptés pour être montés sur les toits sans avoir besoin de renforcer la structure desdits toits, ou encore des modules photovoltaïques à haute tension.

En outre, le procédé décrit ci-avant permet de fabriquer des concentrateurs optiques 1 à faible épaisseur, entre 1cm et quelques centimètres, de sorte à augmenter le rôle de l'ouverture des lentilles optiques dans la dissipation de température en vue de réduire l'élévation de température des cellules photovoltaïques 5 au cours du fonctionnement sous ensoleillement (si l'épaisseur est faible, la paroi transparente 11 pourra contribuer à la dissipation de chaleur).

Du fait de l'utilisation d'un concentrateur optique 1 tel que décrit, chaque cellule photovoltaïque 5 peut être génératrice d'un courant faible (inférieure à 200 milliampères pour une taille de lentille primaire jusqu'à 3 cm de côté) permettant d'utiliser des pistes électriques à faibles sections (inférieure à 300 microns de diamètre pour le courant maximal) de sorte à diminuer les coûts de fabrication.

Il est possible d'utiliser un substrat photovoltaïque avec des cellules, notamment à bas coûts, sans concentrateur optique et ce substrat peut aussi intégrer les cellules 5 qui coopèrent avec la structure optique 1 de telle sorte que la partie directe (le disque solaire) de la lumière vienne par concentration coopérer avec les cellules photovoltaïques à concentrateur optique, et que la lumière diffuse vienne coopérer avec les cellules sans concentrateur optique. Ceci permet de maximiser la production d'électricité même en cas de défaillance d'un traqueur permettant l'orientation des modules en direction du soleil. Par ailleurs, la miniaturisation de la taille des lentilles primaires permet de ne pas dégrader les cellules photovoltaïques du substrat non équipées de concentrateur optique en cas de désalignement de la lumière concentrée.

Selon un autre mode d'exécution du procédé de fabrication, le moule peut alternativement être fermé par deux plaques faisant partie du moule et donc n'étant pas un substrat photovoltaïque et une paroi transparente. Dans un tel mode d'exécution, on met ensuite le substrat photovoltaïque en position relativement à la structure optique durcie ou obtenue par moulage. Par exemple, on fixe la structure optique sur le substrat.

L'invention est aussi relative à un moule tel que décrit précédemment pour la fabrication du concentrateur photovoltaïque, notamment dans le cadre du procédé de fabrication décrit.

L'utilisation d'un substrat photovoltaïque équipé d'une telle structure optique permet d'augmenter le nombre de cellules photovoltaïques pour augmenter la tension de sortie générée par le concentrateur photovoltaïque.

## Revendications

1. Procédé de fabrication d'un concentrateur photovoltaïque comprenant un substrat photovoltaïque (2) muni d'une pluralité de cellules photovoltaïques (5), et une structure optique (1) comprenant un premier étage de lentilles optiques (4) et un deuxième étage de lentilles optiques (3) destinés à coopérer optiquement entre eux, **caractérisé en ce qu'**il comporte les étapes suivantes :
- une fourniture d'un moule (6),
- une formation simultanée du premier étage de lentilles optiques (4) et du deuxième étage de lentilles optiques (3) utilisant ledit moule fourni (6) et mettant en œuvre une étape de remplissage dudit moule (6) par un matériau (100), notamment par injection ou par coulée dudit matériau (100),
en que ce l'étape de fourniture dudit moule (6) est telle que ledit moule fourni (6) comporte une première face (9) munie d'une pluralité de premières cavités (10) délimitant chacune une forme complémentaire à celle d'une lentille optique correspondante du premier étage de lentilles optiques (4) et une deuxième face (7) munie d'une pluralité de deuxièmes cavités (8) délimitant chacune une forme complémentaire à celle d'une lentille optique correspondante du deuxième étage de lentilles optiques (3) et **en ce que** le moule (6) fourni est tel qu'il permet de mouler le premier étage de lentilles optiques (4) et le deuxième étage de lentilles optiques (3) d'une manière telle que le positionnement du premier étage de lentilles optiques (4) dans le moule (6) par rapport au deuxième étage de lentilles optiques (3) dans le moule (6) correspond au positionnement désiré du premier étage de lentilles optiques (4) par rapport au deuxième étage de lentilles optiques (3) dans une configuration d'assemblage du concentrateur photovoltaïque.

2. Procédé selon la revendication précédente, **caractérisé en ce qu'**il comporte les étapes suivantes mises en œuvre avant l'étape de remplissage :
- un report du substrat photovoltaïque (2) sur la deuxième face (7) du moule (6) de telle sorte que chaque cellule photovoltaïque (5) soit placée dans une deuxième cavité (8) correspondante,
- un report d'une paroi transparente (11) sur la première face (9) du moule (6).

3. Procédé selon l'une quelconque des revendications précédentes, **caractérisé en ce que** l'étape de remplissage comporte une étape de guidage du matériau (100) de telle sorte que le matériau (100) vienne remplir chacune des premières cavités (10) et chacune des deuxièmes cavités (8).

4. Procédé selon la revendication 2 et la revendication 3, **caractérisé en ce que** l'étape de guidage comporte l'utilisation d'un réseau de canaux (15) d'écoulement dudit matériau (100) formés dans la deuxième face (7) du moule (6) pour remplir chacune des deuxièmes cavités (8).

5. Procédé selon la revendication précédente, **caractérisé en ce que** les cellules photovoltaïques (5) étant reliées électriquement entre elles par des éléments de liaison électrique formés à la surface du substrat photovoltaïque (2) portant les cellules photovoltaïques (5), l'étape de guidage permet le remplissage du réseau de canaux (15) par le matériau (100) d'où il résulte une encapsulation des éléments de liaison électrique par ledit matériau (100) après durcissement dudit matériau (100).

6. Procédé selon l'une quelconque des revendications précédentes, **caractérisé en ce qu'**il comporte une étape de retrait dudit moule (6) comprenant une désolidarisation du premier étage de lentilles optiques (4) formé par rapport au deuxième étage de lentilles optiques (3) formé, l'étape de retrait dudit moule (6) étant suivie d'une étape d'assemblage du premier étage de lentilles optiques (4) avec le deuxième étage de lentilles optiques (3).

7. Procédé selon la revendication précédente, **caractérisé en ce qu'**il comporte une étape de mise en référencement du substrat photovoltaïque (2) par rapport à la paroi transparente (11) réalisée avant durcissement du matériau (100) pour permettre, après démoulage dudit moule (6), la mise en œuvre de l'étape d'assemblage selon un alignement correspondant à ladite mise en référencement du deuxième étage de lentilles optiques (3) fixé au substrat photovoltaïque (2) par rapport au premier étage de lentilles optiques (4) fixé à ladite paroi transparente (11).

8. Procédé selon l'une quelconque des revendications précédentes, **caractérisé en ce que** le matériau (100) utilisé par l'étape de remplissage est un polymère transparent apte à être mis en forme par coulée ou par injection, notamment un polymère durcissable après coulée ou injection.

9. Procédé selon la revendication précédente, **caractérisé en ce que** l'étape de remplissage étant réalisée par coulée du matériau (100) dans le moule (6), ledit matériau (100) est un PDMS, ou **en ce que** l'étape de remplissage étant réalisée par injection du matériau (100) dans le moule (6) ledit matériau (100) est un PC ou PMMA.

10. Moule pour la fabrication d'une structure optique (1) d'un concentrateur photovoltaïque, ladite structure optique (1) comprenant un premier étage de lentilles optiques (4) et un deuxième étage de lentilles optiques (3) destinés à coopérer optiquement entre eux, ledit moule (6) comportant une première face (9) munie d'une pluralité de premières cavités (10) délimitant chacune une forme complémentaire à celle d'une lentille optique correspondante du premier étage de lentilles optiques (4) et une deuxième face (7) munie d'une pluralité de deuxièmes cavités (8) délimitant chacune une forme complémentaire à celle d'une lentille optique correspondante du deuxième étage de lentilles optiques (3) et en ce que le moule permet de mouler le premier étage de lentilles optiques (4) et le deuxième étage de lentilles optiques (3) d'une manière telle que le positionnement du premier étage de lentilles optiques (4) dans le moule (6) par rapport au deuxième étage de lentilles optiques (3) dans le moule (6) correspond au positionnement désiré du premier étage de lentilles optiques (4) par rapport au deuxième étage de lentilles optiques (3) dans une configuration d'assemblage du concentrateur photovoltaïque.

11. Moule selon la revendication précédente, **caractérisé en ce qu'**il comporte un réseau de canaux (15) formé dans la deuxième face (7) et destiné au remplissage desdites deuxièmes cavités (8), ledit réseau de canaux (15) étant configuré de sorte que son remplissage vienne encapsuler des éléments de liaison électrique reliant électriquement des cellules photovoltaïques (5) d'un substrat photovoltaïque (2) du concentrateur photovoltaïque.

12. Concentrateur optique comprenant une structure optique (1) comprenant un premier étage de lentilles optiques (4) et un deuxième étage de lentilles optiques (3) destinés à coopérer optiquement entre eux, la structure optique étant monobloc ou venue d'une même pièce.

13. Concentrateur photovoltaïque comprenant un substrat photovoltaïque (2) muni d'une pluralité de cellules photovoltaïques (5), et une structure optique (1) comprenant un premier étage de lentilles optiques (4) et un deuxième étage de lentilles optiques (3) destinés à coopérer optiquement entre eux, la structure optique étant monobloc ou venue d'une même pièce.

## Patentansprüche

1. Herstellungsverfahren eines fotovoltaischen Konzentrators, der ein fotovoltaisches Substrat (2) umfasst, das mit einer Vielzahl fotovoltaischer Zellen (5) versehen ist, und eine optische Struktur (1), die eine erste Stufe optischer Linsen (4) und eine zweite Stufe optischer Linsen (3) umfasst, die dazu bestimmt sind, miteinander optisch zusammenzuwirken, **dadurch gekennzeichnet, dass** es die folgenden Schritte umfasst:
- Liefern einer Form (6),
- gleichzeitiges Bilden der ersten Stufe optischer Linsen (4) und der zweiten Stufe optischer Linsen (3) unter Verwenden der gelieferten Form (6) und unter Umsetzen eines Füllschritts der Form (6) durch ein Material (100), insbesondere durch Einspritzen oder Gießen des Materials (100),
dass der Lieferschritt der Form (6) derart ist, dass die gelieferte Form (6) eine erste Fläche (9) umfasst, die mit einer Vielzahl erster Hohlräume (10) versehen ist, die jeweils eine Form komplementär zu der einer optischen Linse abgrenzen, die der ersten Stufe optischer Linsen (4) entspricht, und eine zweite Fläche (7), die mit einer Vielzahl zweiter Hohlräume (8) versehen ist, die jeweils eine Form komplementär zu der einer optischen Linse abgrenzen, die der zweiten Stufe optischer Linsen (3) entspricht, und dass die gelieferte Form (6) derart ist, dass sie es erlaubt, die erste Stufe optischer Linsen (4) und die zweite Stufe optischer Linsen (3) derart zu formen, dass die Positionierung der ersten Stufe optischer Linsen (4) in der Form (6) in Bezug auf die zweite Stufe optischer Linsen (3) in der Form (6) der gewünschten Positionierung der ersten Stufe optischer Linsen (4) in Bezug auf die zweite Stufe optischer Linsen (3) in einer Zusammenfügekonfiguration des fotovoltaischen Konzentrators entspricht.

2. Verfahren nach dem vorstehenden Anspruch, **dadurch gekennzeichnet, dass** es die folgenden Schritte umfasst, die vor dem Füllschritt umgesetzt werden:
- einen Übertrag des fotovoltaischen Substrats (2) auf die zweite Fläche (7) der Form (6) derart, dass jede fotovoltaische Zelle (5) in einem entsprechenden zweiten Hohlraum (8) platziert ist,
- einen Übertrag einer durchsichtigen Wand (11) auf die erste Fläche (9) der Form (6).

3. Verfahren nach einem der vorstehenden Ansprüche, **dadurch gekennzeichnet, dass** der Füllschritt einen Schritt des Führens des Materials (100) derart umfasst, dass das Material (100) jeden der ersten Hohlräume (10) und jeden der zweiten Hohlräume (8) füllt.

4. Verfahren nach Anspruch 2 und Anspruch 3, **dadurch gekennzeichnet, dass** der Führungsschritt das Verwenden eines Netzes aus Abflusskanälen (15) des Materials (100) umfasst, die in der zweiten Fläche (7) der Form (6) gebildet sind, um jeweils zweite Hohlräume (8) zu füllen.

5. Verfahren nach dem vorstehenden Anspruch, **dadurch gekennzeichnet, dass** die fotovoltaischen Zellen (5), die elektrisch miteinander durch elektrische Verbindungselemente verbunden sind, die an der Oberfläche des fotovoltaischen Substrats (2) gebildet sind, fotovoltaische Zellen (5) tragen, wobei der Führungsschritt das Füllen des Netzes aus Kanälen (15) durch das Material (100) erlaubt, woraus eine Kapselung der elektrischen Verbindungselemente durch das Material (100) nach dem Aushärten des Materials (100) resultiert.

6. Verfahren nach einem der vorstehenden Ansprüche, **dadurch gekennzeichnet, dass** es einen Schritt des Entfernens der Form (6) umfasst, der ein Trennen der gebildeten ersten Stufe optischer Linsen (4) in Bezug auf die zweite gebildete Stufe optischer Linsen (3) umfasst, wobei auf den Schritt des Entfernens der Form (6) ein Schritt des Zusammenfügens der ersten Stufe optischer Linsen (4) mit der zweiten Stufe optischer Linsen (3) folgt.

7. Verfahren nach dem vorstehenden Anspruch, **dadurch gekennzeichnet, dass** es einen Schritt der Referenzierungsherstellung des fotovoltaischen Substrats (2) in Bezug auf die durchsichtige Wand (11), die vor dem Aushärten des Materials (100) hergestellt wird, umfasst, um nach dem Abnehmen der Form (6) das Umsetzen des Zusammenfügeschritts entlang einer Ausrichtung zu erlauben, die der Referenzierungsherstellung der zweiten Stufe optischer Linsen (3), die an dem fotovoltaischen Substrat (2) befestigt ist, in Bezug auf die erste Stufe optischer Linsen (4), die an der durchsichtigen Wand (11) befestigt ist, entspricht.

8. Verfahren nach einem der vorstehenden Ansprüche, **dadurch gekennzeichnet, dass** das Material (100), das von dem Füllschritt verwendet wird, ein durchsichtiges Polymer ist, das dazu geeignet ist, durch Gießen oder durch Einspritzen geformt zu werden, insbesondere ein Polymer, das nach dem Gießen oder dem Einspritzen aushärtbar ist.

9. Verfahren nach dem vorstehenden Anspruch, **dadurch gekennzeichnet, dass** der Füllschritt durch Gießen des Materials (100) in die Form (6) ausgeführt wird, wobei das Material (100) ein PDMS ist, oder dass der Füllschritt durch Einspritzen des Materials (100) in die Form (6) ausgeführt wird, wobei das Material (100) ein PC oder ein PMMA ist.

10. Form zum Herstellen einer optischen Struktur (1) eines fotovoltaischen Konzentrators, wobei die optische Struktur (1) eine erste Stufe optischer Linsen (4) und eine zweite Stufe optischer Linsen (3) umfasst, die dazu bestimmt sind, optisch miteinander zusammenzuwirken, wobei die Form (6) eine erste Fläche (9) umfasst, die mit einer Vielzahl erster Hohlräume (10) versehen ist, die jeweils eine Form komplementär zu der einer entsprechenden optischen Linse der ersten Stufe optischer Linsen (4) abgrenzen, und eine zweite Fläche (7), die mit einer Vielzahl zweiter Hohlräume (8) versehen ist, die jeweils eine Form komplementär zu der einer entsprechenden optischen Linse der zweiten Stufe optischer Linsen (3) abgrenzen, und dass die Form das Formen der ersten Stufe optischer Linsen (4) und der zweiten Stufe optischer Linsen (3) derart erlaubt, dass die Positionierung der ersten Stufe optischer Linsen (4) in der Form (6) in Bezug auf die zweite Stufe optischer Linsen (3) in der Form (6) der gewünschten Positionierung der ersten Stufe optischer Linsen (4) in Bezug auf die zweite Stufe optischer Linsen (3) in einer Zusammenfügekonfiguration des fotovoltaischen Konzentrators entspricht.

11. Form nach dem vorstehenden Anspruch, **dadurch gekennzeichnet, dass** sie ein Netz aus Kanälen (15) umfasst, das in der zweiten Fläche (7) gebildet und zum Füllen der zweiten Hohlräume (8) bestimmt ist, wobei das Netz von Kanälen (15) derart konfiguriert ist, dass sein Füllen die elektrischen Verbindungselemente, die die fotovoltaischen Zellen (5) eines fotovoltaischen Substrats (2) des fotovoltaischen Konzentrators elektrisch verbinden, kapselt.

12. Optischer Konzentrator, der eine optische Struktur (1) umfasst, die eine erste Stufe optischer Linsen (4) und eine zweite Stufe optischer Linsen (3) umfasst, die dazu bestimmt sind, miteinander optisch zusammenzuwirken, wobei die optische Struktur einstückig oder aus einem einzigen Teil gebildet ist.

13. Fotovoltaischer Konzentrator, der ein fotovoltaisches Substrat (2) umfasst, das mit einer Vielzahl fotovoltaischer Zellen (5) versehen ist, und eine optische Struktur (1), die eine erste Stufe optischer Linsen (4) und eine zweite Stufe optischer Linsen (3) umfasst, die dazu bestimmt sind, miteinander optisch zusammenzuwirken, wobei die optische Struktur einstückig oder aus einem einzigen Teil gebildet ist.

## Claims

1. Process for manufacturing a photovoltaic concentrator comprising a photovoltaic substrate (2) equipped with a plurality of photovoltaic cells (5), and an optical structure (1) comprising a first optical-lens stage (4) and a second optical-lens stage (3) that are intended to optically interact with each other, **characterized in that** it includes the following steps:
- providing a mould (6);
- simultaneously forming the first optical-lens stage (4) and the second optical-lens stage (3) using said provided mould (6), and implementing a step of filling said mould (6) with a material (100), especially by injecting or pouring said material (100),
**in that** the step of providing said mould (6) is such that said provided mould (6) includes a first face (9) equipped with a plurality of first cavities (10) each delimiting a shape complementary to that of a corresponding optical lens of the first optical-lens stage (4) and a second face (7) equipped with a plurality of second cavities (8) each delimiting a shape complementary to that of a corresponding optical lens of the second optical-lens stage (3) and **in that** the provided mould (6) is such that it allows the first optical-lens stage (4) and the second optical-lens stage (3) to be moulded in such a way that the position of the first optical-lens stage (4) in the mould (6) relative to the second optical-lens stage (3) in the mould (6) corresponds to the position desired for the first optical-lens stage (4) relative to the second optical-lens stage (3) in an assembly configuration of the photovoltaic concentrator.

2. Process according to the preceding claim, **characterized in that** it includes the following steps implemented before the filling step:
- adding the photovoltaic substrate (2) to the second face (7) of the mould (6) such that each photovoltaic cell (5) is placed in a corresponding second cavity (8);
- adding a transparent wall (11) to the first face (9) of the mould (6).

3. Process according to any one of the preceding claims, **characterized in that** the filling step includes a step of guiding the material (100) such that the material (100) fills each of the first cavities (10) and each of the second cavities (8).

4. Process according to claim 2 and claim 3, **characterized in that** the guiding step includes using a network of flow channels (15) formed in the second face (7) of the mould (6) to channel a flow of said material (100) in order to fill each of the second cavities (8).

5. Process according to the preceding claim, **characterized in that** the photovoltaic cells (5) being electrically connected to one another by electrical connection elements formed on the surface of the photovoltaic substrate (2) bearing the photovoltaic cells (5), the guiding step allows the network of channels (15) to be filled with the material (100) and, as a result, the electrical connection elements to be encapsulated by said material (100) after curing of said material (100).

6. Process according to any one of the preceding claims, **characterized in that** it includes a step of removing said mould (6), comprising disengaging the formed first optical-lens stage (4) relative to the formed second optical-lens stage (3), the step of removing said mould (6) being followed by a step of assembling the first optical-lens stage (4) and the second optical-lens stage (3).

7. Process according to the preceding claim, **characterized in that** it includes a step of positioning of the photovoltaic substrate (2) relative to the transparent wall (11), carried out before curing of the material (100), in order to allow, after demoulding of said mould (6), the assembling step to be implemented with an alignment, corresponding to said positioning, of the second optical-lens stage (3) fixed to the photovoltaic substrate (2) relative to the first optical-lens stage (4) fixed to said transparent wall (11).

8. Process according to any one of the preceding claims, **characterized in that** the material (100) used in the filling step is a transparent polymer that is able to be shaped by casting or injection moulding, and especially a polymer that is curable after casting or injection moulding.

9. Process according to the preceding claim, **characterized in that** the filling step being carried out by pouring the material (100) into the mould (6), said material (100) is a PDMS, or **in that** the filling step being carried out by injecting the material (100) into the mould (6), said material (100) is a PC or PMMA.

10. Mould for manufacturing an optical structure (1) for a photovoltaic concentrator, said optical structure (1) comprising a first optical-lens stage (4) and a second optical-lens stage (3) that are intended to optically interact with each other, said mould (6) including a first face (9) equipped with a plurality of first cavities (10) each delimiting a shape complementary to that of a corresponding optical lens of the first optical-lens stage (4) and a second face (7) equipped with a plurality of second cavities (8) each delimiting a shape complementary to that of a corresponding optical lens of the second optical-lens stage (3) and in that the mould allows the first optical-lens stage (4) and the second optical-lens stage (3) to be moulded in such a way that the position of the first optical-lens stage (4) in the mould (6) relative to the second optical-lens stage (3) in the mould (6) corresponds to the position desired for the first optical-lens stage (4) relative to the second optical-lens stage (3) in an assembly configuration of the photovoltaic concentrator.

11. Mould according to the preceding claim, **characterized in that** it includes a network of channels (15) formed in the second face (7) and intended to allow said second cavities (8) to be filled, said network of channels (15) being configured so that filling it leads to encapsulation of electrical connection elements electrically connecting photovoltaic cells (5) of a photovoltaic substrate (2) of the photovoltaic concentrator.

12. Optical concentrator comprising an optical structure (1) comprising a first optical-lens stage (4) and a second optical-lens stage (3) that are intended to optically interact with each other, the optical structure being of integral construction or a single object.

13. Photovoltaic concentrator comprising a photovoltaic substrate (2) equipped with a plurality of photovoltaic cells (5), and an optical structure (1) comprising a first optical-lens stage (4) and a second optical-lens stage (3) that are intended to optically interact with each other, the optical structure being of integral construction or a single object.
